## Europäisches Patentamt

## European Patent Office

## Office européen des brevets

(11) Veröffentlichungsnummer: **0 143 485 B1**

(12) **EUROPÄISCHE PATENTSCHRIFT**

(45) Veröffentlichungstag der Patentschrift:
**13.07.88**

(21) Anmeldenummer: **84201540.6**

(22) Anmeldetag: **25.10.84**

(51) Int. Cl.⁴: **G 01 R 29/00**, G 01 R 29/26, G 01 M 11/00, H 04 B 9/00

(54) Verfahren und Schaltungsanordnung zur Vergrösserung des Signalrauschabstandes eines periodischen elektrischen Signals.

(30) Priorität: **28.10.83 DE 3339146**

(43) Veröffentlichungstag der Anmeldung:
**05.06.85 Patentblatt 85/23**

(45) Bekanntmachung des Hinweises auf die Patenterteilung:
**13.07.88 Patentblatt 88/28**

(84) Benannte Vertragsstaaten:
**DE FR GB IT**

(56) Entgegenhaltungen:
**DE - A - 3 125 140**

**RADIO FERNSEHEN ELECTRONIK, Band 28, Nr. 7, 1979, Seiten 415-418. BERLIN (DD). W. BECKER: "Signal-Mittelwertbildung nach dem Boxcarverfahren". SIXth EUROPEAN CONFERENCE ON OPTICAL COMMUNICATION, University of YORK (GB), 16-19, September 1980 Seiten 156-158. P. HEALEY: "Optical time domain reflectometry by photon counting". LASER FOCUS/ELECTRO OPTICS, Band 19, Nr. 12, Dezember 1983, Seiten 77-84, NEWTON, MASSACHUSETTS (US). S. LETZTER: "Advances in boxcar averaging using digital techniques".**

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL-5621 BA Eindhoven (NL)**

(84) Benannte Vertragsstaaten: **FR GB IT**

(72) Erfinder: **Schulze, Michael, Ober dem Garten 10, D-5203 Much (DE)**

(74) Vertreter: **Meier, Friedrich, Dipl.-Ing. et al, Philips Patentverwaltung GmbH Wendenstrasse 35 Postfach 10 51 49, D-2000 Hamburg 1 (DE)**

## Beschreibung

Die Erfindung betrifft ein Verfahren zur Vergrösserung des Signalrauschabstandes eines periodischen elektrischen Signals sowie eine Schaltungsanordnung zur Durchführung des Verfahrens.

Ein Verfahren zur Vergrösserung des Signalrauschabstandes ist bereits allgemein bekannt. So werden beispielsweise zur Aufbereitung von Rückstreusignalen in Lichtwellenleitern aufeinanderfolgende Rückstreusignale mit einem schnellen digitalen Transientenrekorder aufgezeichnet, um dann unter Heranziehung von Signalwerten aus verschiedenen Rückstreusignalen bei jeweils gleichen Zeitpunkten eine Mittelwertbildung mit Hilfe eines digitalen Rechners durchführen zu können. Diese digitale Verarbeitung ermöglicht eine sehr effektive Rauschunterdrückung. Für eine Verbesserung des Signalrauschabstandes um einen Faktor M werden $M^2$ Rückstreusignale zur Mittelwertbildung benötigt.

Der Nachteil dieses Verfahrens ist in den hohen Kosten für den schnellen digitalen Transientenrekorder sowie in der aufwendigen digitalen Weiterverarbeitung zu sehen.

Aus der DE-OS 3 125 140 ist ferner ein analoges Verfahren zur Verbesserung des Signalrauschabstandes eines Rückstreusignals in Lichtwellenleitern bekannt, bei dem unter Verwendung einer Analogspeicherkette die Rückstreusignale gespeichert und zeitverzögert wieder ausgelesen werden. Ein ausgelesenes Rückstreusignal bzw. dessen Kurvenverlauf wird nun zeitrichtig zu einem nachfolgenden Rückstreusignal punktweise hinzuaddiert und von neuem in die Analogspeicherkette eingelesen. Bei dieser Art der Mittelwertbildung sind für eine gewünschte Verbesserung des Signalrauschverhältnisses um den Faktor M ebenfalls $M^2$ Rückstreusignale erforderlich.

Aufgabe der Erfindung ist es, ein Verfahren und eine Anordnung zur Vergrösserung des Signalrauschabstandes eines periodischen elektrischen Signals anzugeben, mit dem eine effektive Rauschunterdrückung bei einer erheblich geringeren Anzahl von Wiederholungen des zu verbessernden Signals erreicht wird.

Diese Aufgabe wird erfindungsgemäss dadurch gelöst, dass aufeinanderfolgende Signale jeweils unter Ausblendung eines Signal-Teilbereiches integriert werden, dass der Integrationswert dem jeweiligen Signal-Teilbereich zugeordnet wird, wobei alle Signal-Teilbereiche innerhalb des Signalverlaufs nebeneinander liegen, und dass von einem Signal ohne Ausblendung eines Signal-Teilbereiches ein Gesamtintegrationswert gebildet wird, von dem entsprechend der Lage der Signal-Teilbereiche die ihnen zugeordneten Integrationswerte subtrahiert werden.

Das rauschbefreite Signal wird somit aus einer Folge von bei jeder Integrationswertbildung erhaltenen Spannungswerten zurückgewonnen, indem entweder nach Zwischenspeicherung der Folge von Spannungswerten in Analogspeicherketten oder Digitalspeichern (nach A/D-Wandlung) oder direkt die Spannungswerte von dem ohne Ausblendung eines Signal-Teilbereiches erhaltenen Gesamtintegrationswert des Signals subtrahiert werden. Statt der Integrationswerte bzw. des Gesamtintegrationswertes können auch direkt die Mittelwerte bzw. ein Gesamtmittelwert gebildet werden.

Die mit der Erfindung erzielbaren Vorteile bestehen insbesondere darin, dass zur Ermittlung des Signalpegels an einer bestimmten Stelle des Signals immer das gesamte Signal herangezogen wird, dessen Mittelwert beispielsweise sehr viel weniger schwankt als der nur an dem betrachteten Kurvenpunkt aus mehreren Einzelmessungen gebildete Mittelwert. Dies hat zur Folge, dass zur rauschbefreiten Darstellung des gesamten Signals jeder Kurvenpunkt nur einmal berücksichtigt zu werden braucht, was die Messzeit gegenüber den herkömmlichen Messverfahren wesentlich verkürzt.

Nach einer vorteilhaften Weiterbildung der Erfindung sind die Signal-Teilbereiche in ihrer zeitlichen Breite veränderbar, so dass der Verlauf eines Signals mit unterschiedlichem örtlichen Auflösungsvermögen abgetastet werden kann. Eine andere vorteilhafte Ausbildung der Erfindung besteht darin, dass die Signal-Teilbereiche nur in einem interessierenden Bereich des Signalverlaufs gebildet werden, wobei das Signal im restlichen Bereich unterdrückt wird. Hierdurch wird es möglich, nur bestimmte Teilbereiche eines Signals rauschbefreit darzustellen.

Nach einer anderen vorteilhaften Weiterbildung der Erfindung wird das rauschbefreite Signal zeitverzögert zur Anzeige oder Weiterverarbeitung ausgegeben.

Durch die Möglichkeit, das rauschbefreite Signal zeitverzögert, d.h. in erster Linie zeitlich gedehnt wiedergeben zu können, wird man bei der Weiterverarbeitung unabhängig von der oft sehr hohen Wiederholfrequenz (kurze Perioden- bzw. Signaldauer) des verrauschten Signals. Man kann so das rauschbefreite Signal statt mit einem schnellen und teuren Real-time-Oszilloskop oder gar Sampling-Oszilloskop durch ein einfaches, z.B. 10 MHz-Oszilloskop oder gar direkt durch einen Schreiber ausgeben lassen. Eine gedehnte Signalwiedergabe setzt zumeist voraus, dass das vollständige Signal gespeichert ist. Die Wiedergabe erfolgt also auch zeitlich später.

Eine vorteilhafte Schaltungsanordnung zur Durchführung des Verfahrens enthält einen elektrisch steuerbaren Analogschalter, an dessen Eingang das periodische Signal anliegt und dessen Ausgang der Reihe nach mit Integrationsmitteln zur Bildung der Integrationswerte (I) des Signals (S) unter Ausblendung eines Signal-Teilbereiches (TB, TB') bzw. Gesamtintegrationswerte (GI) des Signals (S) ohne Ausblendung eines Signalteilbereiches sowie mit Subtraktionsmitteln (15, 22) mit denen entsprechend der Lage der Signalteilbereiche die zugeordneten Integrationswerte (I) von dem Gesamtintegrationswert (GI) subtrahiert werden, verbunden ist, wobei wenigstens der Analogschalter mit einer Steuerungseinrichtung elektrisch verbunden ist. Die Steuerungseinrichtung und die Subtraktionsmittel können durch einen Mikroprozessor ersetzt sein, wobei zwischen jenem und den Integrationsmitteln ein Analog/Digital-Wandler elektrisch angeordnet ist. Der Mikroprozessor kann dabei ausgangsseitig auch mit einem Digital/Analog-Wandler elektrisch verbunden sein.

Durch die Ansteuerung des Analogschalters kann die Ausblendung der Signal-Teilbereiche im interessierenden Bereich des Signalverlaufs relativ einfach vorgenommen werden. Zu diesem Zweck wird der Analogschalter zu einem gewünschten Zeitpunkt nur kurzzeitig geöffnet, wobei die Öffnungszeit der zeitlichen Breite eines Signal-Teilbereichs entspricht. Die Schaltung selbst benötigt gegenüber bekannten Schaltungen dieser Art relativ wenig Speicherplätze, da zur Rauschverbesserung eines Signals jeweils nur eine der Signal-Teilbereiche entsprechende Anzahl von Integrations- bzw. Mittelwerten sowie zusätzlich ein Gesamtintegrations- bzw. Gesamtmittelwert gespeichert werden müssen. Die Schaltung kann daher relativ einfach und kostengünstig aufgebaut werden. Selbstverständlich ist es auch möglich, bei jeder Bildung eines Integrations- bzw. Mittelwerte gleichzeitig auch einen Gesamtintegrations- bzw. Gesamtmittelwert zu bilden, so dass die Subtraktion zur Rauschbefreiung des Signals sofort vorgenommen werden kann. In diesem Fall benötigt die Schaltung eine noch geringere Anzahl von Speicherplätzen.

Die Zeichnung stellt Ausführungsbeispiele der Erfindung dar. Es zeigen:

Fig. 1 einen Verlauf des periodischen Rückstreusignals eines Lichtwellenleiters,

Fig. 2 ein Zeitdiagramm der Schaltzustände eines Schalters zur Erzeugung der Signal-Teilbereiche,

Fig. 3 eine Schaltungsanordnung nach der Erfindung mit einem Mikroprozessor,

Fig. 4 eine Schaltungsanordnung nach der Erfindung mit Analogspeichern und

Fig. 5 eine Schaltungsanordnung nach der Erfindung ohne zusätzliche Speicherelemente.

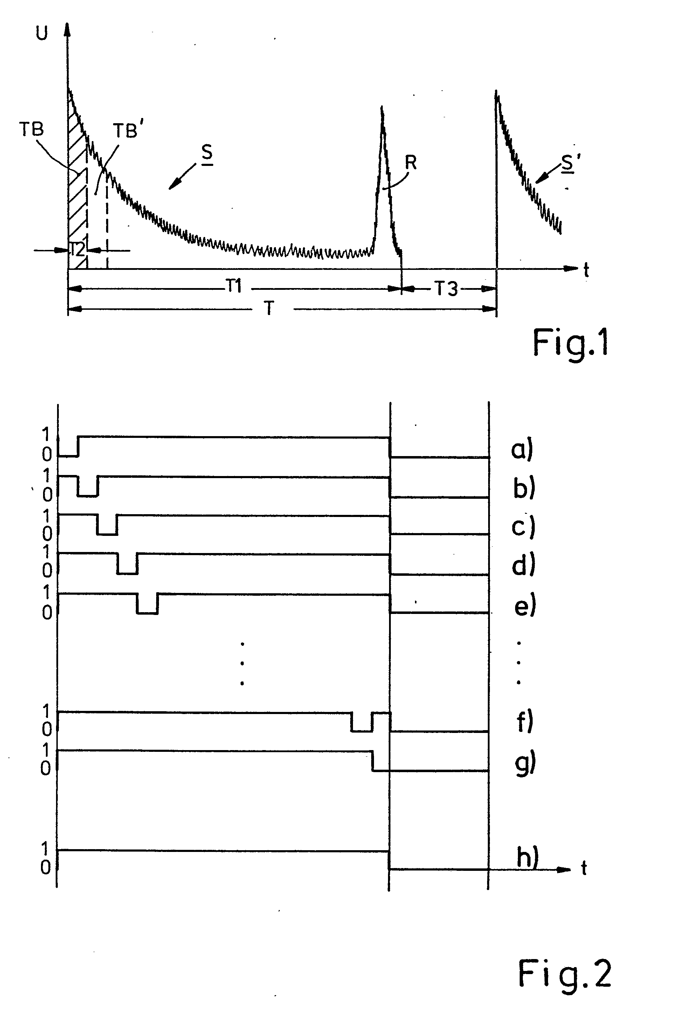

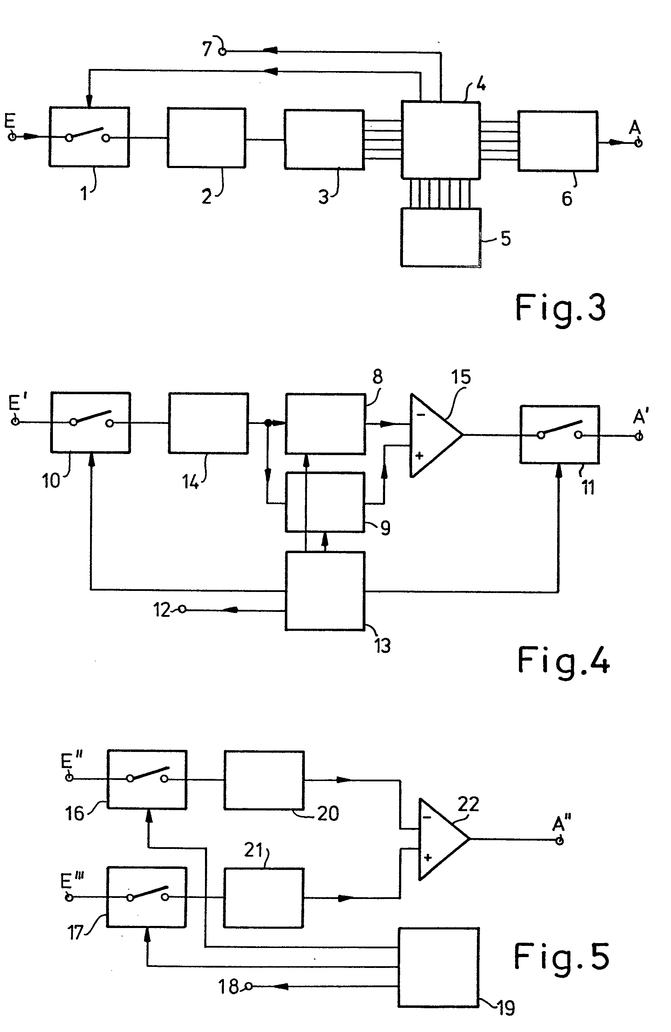

In der Fig. 1 ist ein verrauschtes periodisches elektrisches Signal S dargestellt, das z.B. das Rückstreusignal eines Lichtwellenleiters ist, welches durch periodische Einkoppelung von Strahlung in den Lichtwellenleiter und Messung der aus dem Lichtwellenleiter ausgekoppelten Strahlung an der Einkoppelstelle erhalten wird. Beispielsweise stellt der Signalanteil R die an der Endfläche des Lichtwellenleiters reflektierte Strahlung dar. Das Rückstreusignal S, das die Periode T besitzt, soll in einem gewünschten Bereich T1 vom Rauschen befreit werden. Hierzu wird das Signal S zunächst über eine Periode T integriert, wobei während der Zeiten T2 und T3 das Signals S unterdrückt wird. Zu diesem Zweck ist vor dem Integrationsglied 2 in Fig. 3 ein mit

dem Schaltungseingang E verbundener Schalter 1 angeordnet, dessen zeitliche Schaltzustände in Fig. 2 dargestellt sind. Der Schalter 1 in Fig. 3 ist somit gemäss Fig. 2a während der Zeiten T2 und T3 geöffnet, während er im Zeitraum T1–T2 geschlossen ist. Nur im letzteren Fall wird das Signal S integriert. Hierbei ist der Signal-Teilbereich TB ausgenommen (vgl. Fig. 2a), dem jedoch der so erhaltene Integrationswert zugeordnet wird.

Das darauffolgende Rückstreusignal S' wird ebenfalls integriert, jedoch wird hier neben dem Bereich T3 der Teilbereich TB' zu einem anderen Zeitpunkt ausgeblendet. Er liegt jetzt, wie Fig. 2b zeigt, auf der Zeitachse t, um den Betrag T2 verschoben. Hierzu wurde der Schalter 1 erst nach der Zeit T2 geöffnet und für die gleiche Zeit offengehalten. Der so erhaltene Integrationswert wird wiederum dem nunmehr um T2 verschobenen Signal-Teilbereich TB zugeordnet, usw. Es werden so viele Rückstreusignale S, S', S" usw. integriert, bis der Teilbereich TB über den gesamten Signalverlauf verschoben worden ist (vgl. Fig. 2g). Der gesamte Signalverlauf wird somit von nebeneinander liegenden Teilbereichen erfasst.

Zusätzlich wird ein Rückstreusignal ohne Ausblendung eines Teilbereiches im gewünschten Bereich T1 integriert, wie die Fig. 2h zeigt.

Die vom Integrator 2 in Fig. 3 gelieferten Integrationswerte I (entsprechend Fig. 2a bis g) sowie der Gesamtintegrationswert GI (entsprechend Fig. 2h) werden in einem Analog/Digital-Wandler 3 digitalisiert. Ein nachgeschaltetes Mikroprozessor-System 4 mit zugehörigem RAM-Speicherblock 5 übernimmt die Speicherung sowie die Rückgewinnung eines rauschbefreiten Signals aus diesen Werten. Hierzu werden die den Teilbereichen TB, TB' usw. zugeordneten Integrationswerte entsprechend der Lage der Teilbereiche relativ zum Signalverlauf vom jeweils selben Gesamtintegrationswert subtrahiert. Das als Ergebnis erhaltene rauschbefreite Signal wird dann anschliessend einem Digital/Analog-Wandler 6 zugeführt, um erforderlichenfalls eine analoge Weiterverarbeitung über den Schaltungsausgang A zu ermöglichen. Das Mikroprozessorsystem 4 übernimmt ferner neben der Steuerung des Analogschalters 1 gemäss Fig. 2 auch die Triggerung des signalauslösenden Systems über eine Klemme 7. Dieses System kann beispielsweise ein Laser sein (nicht dargestellt).

In Fig. 4 ist eine Schaltung mit Analogspeichern 8 und 9 dargestellt, die ebenso wie die Analogschalter 10 und 11 und das signalerzeugende System über den Anschluss 12 unter der Kontrolle einer Steuereinrichtung 13 stehen. Der Schalter 10 ist dabei mit einem Schaltungseingang E' und der Schalter 11 mit einem Schaltungsausgang A' verbunden.

Nachdem, wie bereits im Zusammenhang mit den Fig. 1 bis 3 erwähnt, die durch den Integrator 14 erzeugten Integrationswerte I im Analogspeicher 8 der Reihe nach gespeichert worden sind, sorgt die Steuereinrichtung 13 nunmehr dafür, dass der Gesamtintegrationswert GI in den Speicher 9 überführt wird. Die Steuereinrichtung 13 bewirkt dann, dass die Integrationswerte I nacheinander aus dem Speicher 8 austreten und jeweils von dem im Speicher 9 gespeicherten Gesamtintegrationswert GI im Subtrahierglied 15 subtrahiert werden. Selbstverständlich kann der Gesamtintegrationswert GI auch vor den jeweiligen Integrationswerten erzeugt werden.

Der Schalter 11 verhindert, dass während des Einlesevorganges in die Analog-Speicherkette am Ausgang der gesamten Schaltungsanordnung irrelevante Signale aufgrund früherer eingelesener oder zufälliger Speicherinhalte auftreten. Der Schalter 11 gibt das Ausgangssignal erst frei, wenn in 8 alle Teilintegrationswerte und in 9 der Gesamtwert gespeichert sind und 15 wieder das rauschbefreite «Originalsignal» zusammensetzt.

Die Schaltung nach Fig. 5 besitzt zwei mit Schaltungseingängen E" bzw. E''' verbundene Analogschalter 16 und 17, die ebenso wie das signalerzeugende System über einen Anschluss 18 unter der Kontrolle einer Steuereinrichtung 19 stehen. Die Schalter 16 und 17 sind jeweils mit Integrationsgliedern 20, 21 verbunden, die ihrerseits mit den Eingängen eines Subtrahiergliedes 22 verbunden sind. Entsprechend den Fig. 3 und 4 werden die Integrationswerte durch Ansteuerung des Schalters 16 und Integration im Integrationsglied 20 erhalten. Über den Schalter 17 und das Integrationsglied 21 werden gleichviele Gesamtintegrationswerte GI erzeugt, so dass nach der Erzeugung jeweils eines Integrationswertes I gleichzeitig auch ein Gesamtintegrationswert GI zur Verfügung steht, von dem im Subtrahierglied 22 der Integrationswert I subtrahiert wird. Bei genügend schneller Verschiebung des Signal-Teilbereiches TB über den gewünschten Signalverlauf-Abschnitt (T1) ist somit über den Schaltungsausgang A" eine Echtzeit-Darstellung des rauschärmeren Rückstreusignals, z.B. auf einem Monitor oder Oszillographen, möglich.

Die in den Fig. 3 bis 5 beschriebenen Schaltungsanordnungen können selbstverständlich auch so ausgebildet sein, dass statt der Integrationswerte I bzw. des Gesamtintegrationswertes GI entsprechende Mittelwerte M bzw. ein Gesamtmittelwert GM gebildet werden können. Darüber hinaus können mit dem Verfahren und den Schaltungen nicht nur Rückstreusignale in Lichtwellenleitern aufbereitet werden, sondern allgemein jede Art von verrauschten periodischen Signalen.

Die Vorteile des erfindungsgemässen Verfahrens und der hierzu beschriebenen Schaltungsanordnungen liegen in einer sehr effektiven Rauschbefreiung, da das gesamte Signal zur Integration bzw. Mittelwertbildung benutzt wird, und in den relativ geringen Kosten, da konventionelle Analogbauteile und preislich günstige, langsame digitale Schaltelemente verwendet werden können. Ferner ist das Verfahren universell einsetzbar, da aufgrund der Verwendung eines Mikroprozessorsystems über Software-Änderungen leicht eine Anpassung an beliebige Messaufgaben und Problemstellungen möglich ist.

**Patentansprüche**

1. Verfahren zur Vergrösserung des Signalrauschabstandes eines periodisch elektrischen Signals, dadurch gekennzeichnet, dass aufeinanderfolgende Signale (S) jeweils unter Ausblendung eines Signal-Teilbereiches (TB, TB') integriert werden, dass der Integrationswert (I) dem jeweiligen Signal-Teilbereich zugeordnet wird, wobei alle Singal-Teilbereiche innerhalb des Signalverlaufs nebeneinander liegen, und dass von einem Signal ohne Ausblendung eines Signal-Teilbereiches ein Gesamtintegrationswert (GI) gebildet wird, von dem entsprechend der Lage der Signal-Teilbereiche die ihnen zugeordneten Integrationswerte (I) subtrahiert werden.

2. Verfahren nach Anspruch 1, dadurch gekennzeichnet, dass aus den Integrationswerten (I) bzw. dem Gesamtintegrationswert (GI) jeweils Mittelwerte (M) bzw. ein Gesamtmittelwert (GM) gebildet werden.

3. Verfahren nach Anspruch 1 oder 2, dadurch gekennzeichnet, dass die Signal-Teilbereiche (TB, TB') in ihrer zeitlichen Breite veränderbar sind.

4. Verfahren nach Anspruch 1, 2 oder 3, dadurch gekennzeichnet, dass die Signal-Teilbereiche (TB, TB') nur in einem interessierenden Bereich des Signalverlaufs gebildet werden, wobei das Signal im restlichen Bereich (T3) unterdrückt wird.

5. Verfahren nach einem oder mehreren der Ansprüche 1 bis 4, dadurch gekennzeichnet, dass das rauschbefreite Signal zeitverzögert zur Anzeige oder Weiterverarbeitung ausgegeben wird.

6. Schaltungsanordnung zur Durchführung des Verfahrens nach einem oder mehreren der Ansprüche 1 bis 5, gekennzeichnet durch einen elektrisch steuerbaren Analogschalter (1, 10, 16, 17), an dessen Eingang das periodische Signal anliegt, und dessen Ausgang der Reihe nach mit Integrationsmitteln (2, 14, 20, 21) zur Bildung der Integrationswerte (I) des Signals (S) unter Ausblendung eines Signal-Teilbereiches (TB, TB') bzw. Gesamtintegrationswerte (GI) des Signals (S) ohne Ausblendung eines Signalteilbereiches sowie mit Subtraktionsmitteln (15, 22), mit denen entsprechend der Lage des Signalteilbereichs die zugeordneten Integrationswerte (I) von dem Gesamtintegrationswert (GI) subtrahiert werden, verbunden ist, wobei wenigstens der Analogschalter mit einer Steuerungseinrichtung (13, 19) elektrisch verbunden ist.

7. Schaltungsanordnung nach Anspruch 6, dadurch gekennzeichnet, dass die Steuerungseinrichtung und die Subtraktionsmittel durch einen Mikroprozessor (4) gebildet sind, wobei zwischen diesem und den Integrationsmitteln (2) ein Analog/Digital-Wandler (3) elektrisch angeordnet ist.

8. Schaltungsanordnung nach Anspruch 7, dadurch gekennzeichnet, dass der Mikroprozessor (4) ausgangsseitig mit einem Digital/Analog-Wandler (6) elektrisch verbunden ist.

## Claims

1. A method of increasing the signal-to-noise ratio of a periodic electrical signal characterized in that successive signals (S) are integrated each time whilst fading out a signal subrange (TB, TB'), in that the integration value (I) is associated with the rspective signal subrange, all signal subranges within the signal variation being located beside each other, and in that, without fading out a signal subrange, from a signal an overall integration value (GI) is formed, from which are subtracted in accordance with the position of the signal subranges the integration values (I) associated with them.

2. A method as claimed in Claim 1, characterized in that average values (M) and an overall average value (GM), respectively, are formed each time from the integration values (I) and the overall integration value (GI), respectively.

3. A method as claimed in Claim 1 or 2, characterized in that the signal subranges (TB, TB') can be varied in time width.

4. A method as claimed in Claim 1, 2 or 3, characterized in that the signal subranges (TB, TB') are formed only in an interesting range of the signal variation, the signal in the remaining range (T3) being suppressed.

5. A method as claimed in any one of Claims 1 to 4, characterized in that the signal freed from noise is delivered with a time delay for indication or further processing.

6. A circuit arrangement for carrying out the method claimed in any one of Claims 1 to 5, characterized by an electrically controllable analogue switch (1, 10, 16, 17), to whose input the periodic signal is applied and whose output is successively connected to integration means (2, 14, 20, 21) for forming the integration values (I) of the signal (S) whilst fading out a signal subrange (TB, TB') and an overall integration value (GI), respectively, of the signal (S) without fading out a signal subrange and to subtraction means (15, 22), by which in accordance with the position of the signal subranges the associated integration values (I) are subtracted from the overall integration value (GI), at least the analogue switch being electrically connected to a control device (13, 19).

7. A circuit arrangement as claimed in Claim 6, characterized in that the control device and the subtraction means are constituted by a microprocessor (4), an analogue-to-digital converter (3) being electrically connected between this microprocessor and the integration means (2).

8. A circuit arrangement as claimed in Claim 7, characterized in that the microprocessor (4) is electrically connected at its output to a digital-to-analogue converter (6).

## Revendications

1. Procédé pour augmenter le rapport signal-bruit d'un signal électrique périodique, caractérisé en ce que des signaux (S) successifs sont intégrés chaque fois avec suppression d'un domaine partiel de signal (TB, TB'), que la valeur d'intégration (I) est associée au domaine partiel de signal en question, tous les domaines partiels de signal dans le tracé du signal étant disposés uns à côté des autres et qu'à partir d'un signal est formée, sans suppression d'un domaine partiel de signal, une valeur d'intégration globale (GI), de laquelle sont soustraites, en fonction de la position des domaines partiels de signal, les valeurs d'intégration (I) qui y sont associées.

2. Procédé suivant la revendication 1, caractérisé en ce que des valeurs moyennes (M) ou une valeur moyenne globale (GM) sont formées chaque fois à partir des valeurs d'intégration (I) ou de la valeur d'intégration globale (GI).

3. Procédé suivant la revendication 1 ou 2, caractérisé en ce que l'étendue dans le temps des domaines partiels de signal (TB, TB') peut être modifiée.

4. Procédé suivant la revendication 1, 2 ou 3, caractérisé en ce que les domaines partiels de signal (TB, TB') ne sont formés que dans un domaine intéressant du tracé de signal, le signal étant supprimé dans le domaine restant (T3).

5. Procédé suivant l'une quelconque des revendications 1 à 4, caractérisé en ce que le signal débarrassé du bruit est fourni retardé dans le temps pour l'affichage ou le post-traitement.

6. Montage de circuit pour réaliser le procédé suivant l'une quelconque des revendications 1 à 5, caractérisé par un commutateur analogique (1, 10, 16, 17) pouvant être commandé électriquement, dont l'entrée reçoit le signal périodique et dont la sortie est connectée en série à des moyens d'intégration (2, 14, 20, 21) pour former les valeurs d'intégration (I) du signal (S) avec suppression d'un domaine partiel de signal (TB, TB') ou une valeur d'intégration globale (GI) du signal (S) sans suppression d'un domaine partiel de signal, ainsi qu'à des moyens de soustraction (15, 22) au moyen desquels, en fonction de la position des domaines partiels de signal, les valeurs d'intégration (I) associées sont soustraites de la valeur d'intégration globale (GI), le commutateur analogique au moins étant connecté électriquement à un dispositif de commande (13, 19).

7. Montage de circuit suivant la revendication 6, caractérisé en ce que le dispositif de commande et les moyens de soustraction sont formés par un microprocesseur (4), un convertisseur analogique-numérique (3) étant connecté électriquement entre ce microprocesseur et les moyens d'intégration (3).

8. Montage de circuit suivant la revendication 7, caractérisé en ce que le microprocesseur (4) est connecté électriquement du côté de sortie à un convertisseur numérique-analogique (6).

Fig.1

Fig.2

Fig.3

Fig.4

Fig.5